# EUROPEAN PATENT APPLICATION

(11) **EP 2 642 837 A1**
(43) Date of publication of application: **25.09.2013**
(21) Application number: 12160338.5
(22) Date of filing: 20.03.2012
(51) Int. Cl.: H05K 3/14

(54) **Conductive pattern film substrate and manufacturing method**

(71) Applicant: Chang, Jacky, Taoyuan City, Taoyuan County 330 (TW); Wu, Shou-Bao, Taoyuan City, Taoyuan County 330 (TW); Lu, Chao-Fu, Taoyuan City, Taoyuan County 330 (TW); Ting, Chien-Chun, New Taipei City 220 (TW); Ho, Yi-Shueh, Taipei City 104 (TW); Lin, Eric, Taixi Township, Yunlin County 636 (TW); Liu, Song-Jhe, New Taipei City 251 (TW)
(72) Inventor: Chang, Jacky, 330 Taoyuan City, Taoyuan County (TW); Lin, Eric, 636 Taixi Township, Yunlin County (TW); Liu, Song-Jhe, 251 New Taipei City (TW)
(74) Representative: Pallini, Diego

(57) **Abstract**

A conductive pattern film substrate and manufacturing method for combining two anisotropic materials, namely a patterned body and a film layer, without assistance from an intermediate layer. The method includes producing a thermal spraying source for performing a heating operation on a film material to prepare the film material for thermal spraying or semi-thermal spraying and thereby decompose the film material into film particles; and spraying the film particles to a pattern layer disposed on the body and having the pattern by the thermal spraying source to form the film layer having the film particle on the pattern layer, thereby enabling the body to embody electrical characteristics of the pattern.

## Description

### FIELD OF THE INVENTION

The present invention relates to conductive pattern film substrates and manufacturing methods, and more particularly, to a substrate for forming a conductive pattern film on a body (comprising ceramic, plastic, polymeric plastic, glass, metal, or the like, for example) and a method thereof.

### BACKGROUND OF THE INVENTION

According to related prior art, a 3-dimension circuit is applicable to a casing of an electronic device, and a circuit layout of a printed circuit board (PCB) is formed on the casing by laser technology and electroplating technology. For example, an antenna is formed on the casing by laser direct structuring (LDS).

However, the aforesaid laser-shaping manufacturing process has drawbacks, such as high costs, an intricate process, a low conforming rate of a finished product, and an environmentally unfriendly electroplating process. For example, the laser-shaping technology entails performing laser etching with an expensive dedicated plastic material (such as a modified plastic material) and then performing three electroplating processes (copper electroplating, nickel electroplating, and gold electroplating) to finalize the circuit layout of the 3-dimension circuit.

Furthermore, to overcome the aforesaid drawbacks of the prior art, the antenna is manufactured by means of an intermediate cladding layer, such as a conductive paint (also known as conductive coating) which is produced by combining conductive metal particles with a polymer material. The manufacturing process of the antenna usually involves enabling a conductive paint to substitute for a dedicated plastic material that has to be activated by laser in accordance with the laser-shaping technology.

Although the aforesaid technique dispenses with a dedicated plastic material, the use of a conductive paint has its own disadvantages. For example, the manufacturing process requires a large amount of solvent, filler, and additive, such as polymer resin. The additive is likely to bind with conductive metal particles to thereby produce a large amount of volatile organic compounds(VOC) waste gas pollution and thus compromise environmental protection.

Accordingly, it is imperative to overcome the drawbacks of the prior art by a carrier and a conductive pattern film forming method put forth by the present invention.

### SUMMARY OF THE INVENTION

It is an objective of the present invention to provide a conductive pattern film substrate manufacturing method for combining directly two anisotropic materials, namely a patterned body and a film layer, without assistance from an intermediate layer.

Another objective of the present invention is to provide a conductive pattern film substrate for forming multi-dimension electrical pattern on the body to transmit and receive electrical signals, and to effectuate anti-electromagnetic interference, electromagnetic shielding, and heat conduction.

Yet another objective of the present invention is to provide the aforesaid manufacturing method and the substrate for melting and transforming a metal (such as zinc, copper, silver, stainless steel, aluminum, gold, or the like) into tiny metal particles (also known as minute particles) instantaneously by a thermal spraying source, spraying directly the tiny metal particles to a body (made of a material, such as plastic, plastic film, ceramic, metal, or glass) having a pattern layer, forming a metal-containing film layer on the body by particle stacking, thereby enabling the multi-dimension pattern layer (such as an antenna pattern, an electrical circuit pattern, or any other appropriate pattern) to acquire the electrical characteristics intended by the pattern.

In order to achieve the above and other objectives, the present invention provides a conductive pattern film substrate manufacturing method for combining two anisotropic materials, namely a patterned body and a film layer, without assistance from an intermediate layer, the method comprising the steps of: producing a thermal spraying source for performing one of a heating operation and a spraying operation; performing the heating operation on a film material to prepare the film material for at least one of thermal spraying and semi-thermal spraying, thereby melt the film material and transform it into ultra-fine particles (or small molecules) to be shot onto the surface of aforesaid substrate into film particles; forming a pattern layer on the body according to the pattern; and spraying the film particles to the body by the spraying operation of the thermal spraying source to form the film layer containing the film particles on the pattern layer.

In order to achieve the above and other objectives, the present invention provides a conductive pattern film substrate comprising a body, a pattern layer, and a film layer. The body is made of a first material. The pattern layer is embedded in the body and has a pattern for producing electrical characteristics. The film layer is made of a second material different from the first material and directly formed on the pattern layer by a thermal spraying source acting on the second material to enable the pattern layer to acquire electrical characteristics of the pattern by the film layer.

Compared with the prior art, the present invention provides a conductive pattern film substrate and a manufacturing method for forming a functional pattern layer on a body (made of a material, such as ceramic, plastic, polymeric plastic, glass, metal, or the like) according to a pattern (such as an antenna pattern, an electrical circuit pattern, or a pattern of an appropriate shape) designed by a user, forming a film layer (such as zinc, copper, aluminum, gold, iron, nickel, chromium, or a combination thereof) on the pattern layer directly, thereby enabling the film layer to acquire electrical characteristics of the pattern according to the pattern layer, and thereby combining two anisotropic materials without assistance from an intermediate layer (also known as a medium layer) which is otherwise required by the prior art.

### BRIEF DESCRIPTION OF THE DRAWINGS

Objectives, features, and advantages of the present invention are hereunder illustrated with specific embodiments in conjunction with the accompanying drawings, in which:

FIG. 1 is a flow chart of a conductive pattern film substrate manufacturing method according to the first embodiment of the present invention;

FIG. 2 is a flow chart of the conductive pattern film substrate manufacturing method according to the second embodiment of the present invention;

FIG. 3 is a structural schematic view of a conductive pattern film substrate according to the first embodiment of the present invention;

FIG. 4 is a structural schematic view of a body in the form of a sticker shown in FIG. 3; and

FIG. 5 is a structural schematic view of a mask layer shown in FIG. 3.

### DETAILED DESCRIPTION OF THE PREFERRED EMBODIMENTS

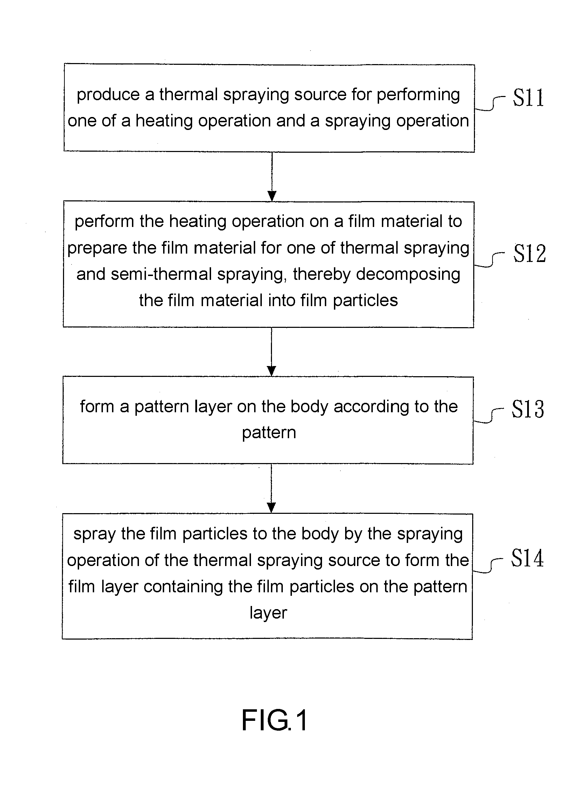

Referring to FIG. 1, there is shown a flow chart of a conductive pattern film substrate manufacturing method according to the first embodiment of the present invention. As shown in FIG. 1, the conductive pattern film substrate manufacturing method for combining two anisotropic materials, namely a patterned body and a film layer, without assistance from an intermediate layer. The body comes in the form of a sticker, a tablet PC casing, a notebook computer casing, a handheld electronic device casing, or a casing for any other electronic device.

The process flow of the conductive pattern film substrate manufacturing method starts from step S11 that involves producing a thermal spraying source for performing a heating operation or a spraying operation. In this step, depending on the form of energy, the thermal spraying source is of two types, namely a thermal source and an electrical source. For example, thermal spraying source can be produced by combustion flame spraying, powder flame spraying, wire flame spraying, rod flame spraying, high velocity oxygen fuel spraying (HVOF), cold spraying, non-penetrating plasma arc spraying, wire and electric arc spraying, direct current air plasma spraying, RF air plasma spraying, or vacuum plasma spraying.

In step S12, the heating operation is performed on a film material to prepare the film material for thermal spraying or semi-thermal spraying such that the film material can be decomposed into film particles. For example, a metal-containing film material is heated up and decomposed into metal particles. For example, the metal is pure zinc, pure copper, pure aluminum, pure gold, pure iron, pure nickel, pure chromium, the like, or an alloy thereof.

Step S13 involves forming a pattern layer on the body according to the pattern. In this step, the pattern layer is formed on the body according to the design of the pattern. The pattern is designed to meet the requirement of electrical characteristics (or electrical functions). For example, the pattern is an antenna pattern, an electrical circuit pattern, or a pattern of any appropriate shape.

Step S14 involves spraying the film particles to the body by the spraying operation of the thermal spraying source to form the film layer containing the film particles on the pattern layer. In this step, spray the metal-containing film particles to the body and/or the pattern layer at high speed, such that the pattern layer acquires the electrical characteristics of the pattern truly after being covered with the film layer having metallic characteristics.

For example, if the pattern layer is formed according to an antenna pattern, the pattern layer can function as a metal antenna for transmitting and receiving electrical signals after being sprayed and covered with the metal-containing film particles.

In an embodiment, one of the pattern layer and the film layer is etched and shaped by positive etching or negative etching performed by an etching source. In an embodiment, the pattern layer having a trench of a depth is formed on the body by etching and shaping. That is to say, the pattern layer has the trench, such that the pattern layer on the body is conspicuous. Furthermore, the etching source is laser etching, mechanical processes, or chemical etching processes.

Furthermore, the positive etching is defined as a process that entails spraying the film particles to the whole surface of the body to form the film layer thereon, removing a non-patterned portion of the film layer by the etching source to leave a patterned-portion of the film layer intact, thereby protruding the pattern layer having the film layer from the body. The negative etching is defined as a process that entails etching the pattern layer on a pattern-required portion of the body by the etching source, spraying the film particles to the pattern layer, thereby forming the film layer on the pattern layer. For example, the pattern layer is formed by the negative etching based on the pattern by means of a mask layer or a mask casing and by means of the direct use of laser etching, mechanical processing, or chemical etching, for example.

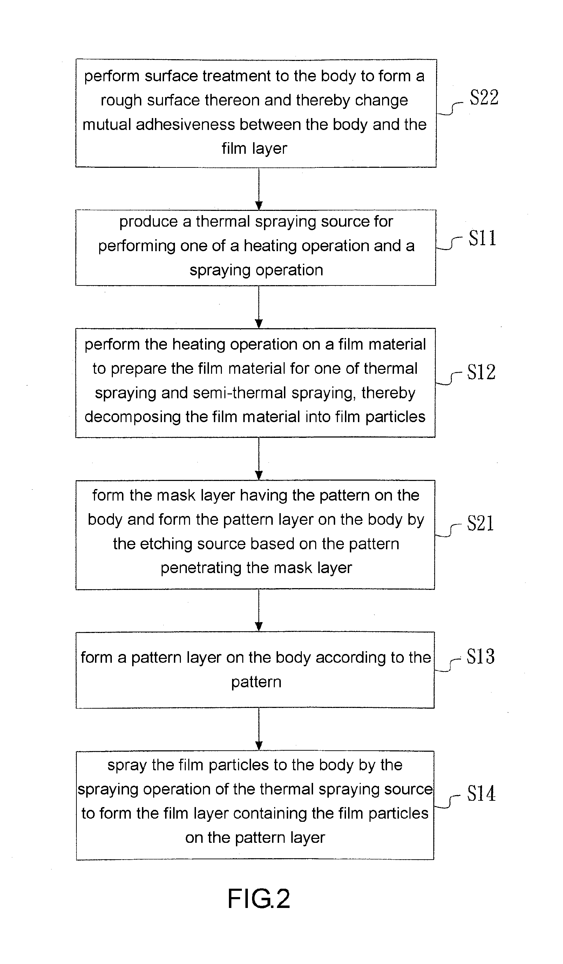

Referring to FIG. 2, there is shown a flow chart of the conductive pattern film substrate manufacturing method according to the second embodiment of the present invention. As shown in FIG. 2, in addition to the aforesaid steps S11∼S14, the conductive pattern film substrate manufacturing method further comprises step S21 that entails forming the mask layer having the pattern on the body and forming the pattern layer on the body by the etching source based on the pattern penetrating the mask layer. This step applies to two embodiments. In one of the two applicable embodiments, a hole corresponding in position to the pattern is formed in the mask layer or the mask casing, and the body is covered with the mask layer, such that the etching source performs etching on the body through the hole, so as to form the pattern layer on the body. In the other applicable embodiment, the body is covered with the mask layer (or the mask casing), and the required pattern or an additional pattern is drawn on the mask layer, such that the etching source forms the pattern layer on the mask layer and the body according to the pattern. For example, the mask layer enables the pattern layer to be formed on the body by a mask means, such as an adhesive tape, printing, liquid spraying, immersion coating, shower coating, or the mask casing.

After the pattern layer is finalized, the mask layer can be selectively removed.

In step S14, the mask layer is effective in reducing the amount of the film particles sprayed. It is because the film particles are precisely sprayed to a pattern layer-covered portion of the body only, and thus the film particles are unlikely to be wrongly sprayed to other portions of the body.

Furthermore, the conductive pattern film substrate manufacturing method further comprises step S22 that entails performing surface treatment to the body so as to form a rough surface thereon and thereby change the mutual adhesiveness between the body and the film layer. In this step, surface treatment, such as sandblasting, chemical coarsening, laser etching, mechanical processing, or corona discharge process, is performed to the surface of the body to enhance the mutual adhesiveness between the body and the film layer.

Illustrative, rather than restrictive, of the present invention, various process combination aspects are put forth in accordance with the aforesaid steps as follows:

Process Combination Aspect 1

body -> mask coating -> perform laser etching on the pattern according to the mask layer -> thermal spraying source -> remove residual mask coating

Process Combination Aspect 2

body -> thermal spraying source -> laser etching

Process Combination Aspect 3

body -> thermal spraying source -> chemical etching

Process Combination Aspect 4

body -> a mask jig with the built-in pattern -> thermal spraying source -> remove the mask jig with the built-in pattern

Process Combination Aspect 5

body -> mask jig -> thermal spraying source -> remove the mask jig -> laser etching trimming

Process Combination Aspect 6

body -> mask layer package (such as paper adhesive tape)-> laser etching a pattern -> thermal spraying source -> remove package material

Process Combination Aspect 7

body -> print mask coating -> thermal spraying source -> remove mask coating

Process Combination Aspect 8

body -> mount the mask jig -> spray mask coating -> unmount the mask jig -> thermal spraying source -> remove coating

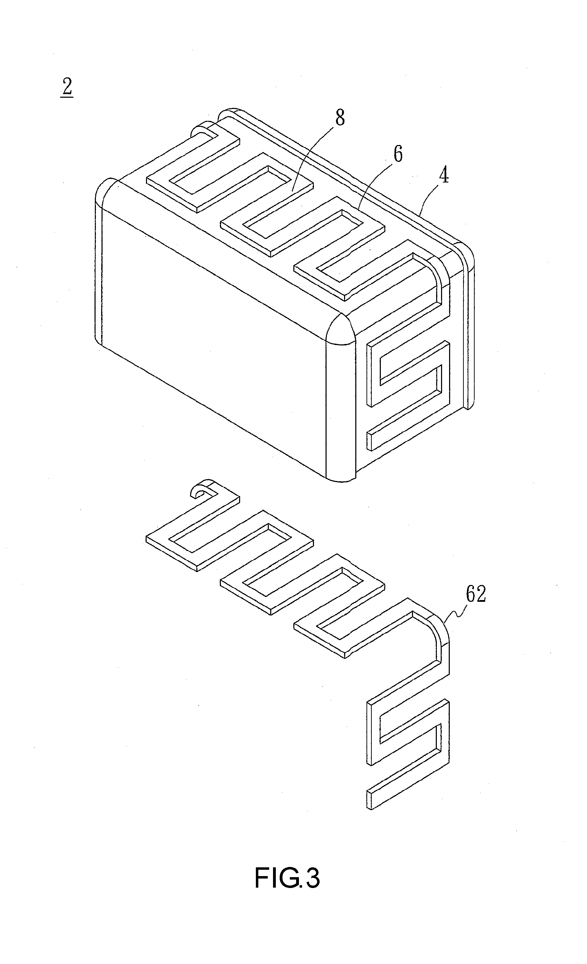

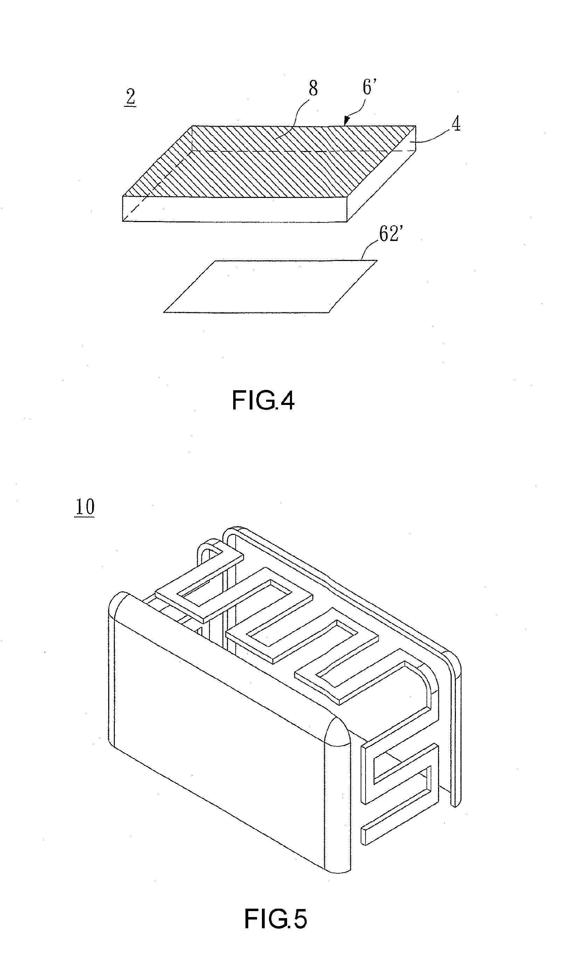

Referring to FIG. 3, there is shown a structural schematic view of a conductive pattern film substrate according to the first embodiment of the present invention. As shown in FIG. 3, a conductive pattern film substrate 2 comprises a body 4, a pattern layer 6, and a film layer 8. The body 4 is made of a first material. For example, the first material is one selected from the group consisting of acrylonitrile-butadiene-styrene copolymer (ABS), polycarbonate (PC), acrylonitrile-butadiene-styrene-polycarbonate copolymer (ABS+PC), polyethylene terephthalate (PET), polypropylene (PP), polyurethane (PU), polyimide (PI), polyamide (PA), poly(butylene terephthalate) (PBT), poly(methyl methacrylate) (PMMA), ceramic, metal, glass, or a combination thereof. For example, the body 4 is a casing (shown in FIG. 3) of an electronic device or a sticker (shown in FIG. 4.)

The pattern layer 6 is embedded in the body 4. The pattern layer 6 has a pattern 62 for producing electrical characteristics. The pattern 62 is an antenna pattern or an electrical circuit pattern. The pattern 62 has a variant, that is, a pattern 62' which is of any shape. In this regard, the pattern layer 6 can be formed in the following illustrative aspects.

In the first aspect, the pattern layer 6 having the pattern 62 is etched on the body 4 directly with the etching source.

In the second aspect, the pattern layer 6 is etched by the etching source 10 according to the pattern 62 on a mask layer 10 (as shown in FIG. 5), and the mask layer 10 is selectively removed after the pattern layer 6 is finalized.

In the third aspect, the pattern layer 6 having the pattern 62 is formed on the mask layer 10 and/or the body 4 by the etching source 10 according to the pattern 62 external thereto.

In the fourth aspect, a pattern layer 6' having the pattern 62' which is rectangular for example is directly formed on the body 4.

In the first through third aspects, the pattern layer 6 having an antenna or an electrical circuit for example is directly formed on the body 4. In an embodiment, the etching source forms the pattern layer 6 on the body 4 by etching and shaping according to the pattern 62. In an embodiment, the pattern layer 6 formed on the body 4 comes in the form of a trench, and the film layer 8 formed on the pattern layer 6 is of a thickness not larger than (equal to or less than) the depth of the trench.

In the fourth aspect, for example, the shape of the body 4 is deemed the shape of the pattern layer 6'. For example, if the body 4 is shaped like a sticker, the pattern layer 6' will be similar or identical to the body 4 in shape and size.

Furthermore, the film layer 8 is made of a second material which is different from the first material. The film layer 8 is directly formed on the pattern layer 6 on the body 4 by the thermal spraying source to enable the film layer 8 to acquire electrical characteristics of the pattern 62 according to the pattern layer 6. For example, the second material is one selected from the group consisting of zinc, copper, aluminum, gold, iron, nickel, chromium, or a combination thereof. The second material comes in the form of powder, wire, or rod. The film layer 8 is formed, by deposition, from the particles which are produced by the thermal spraying source for use with the aforesaid method and contain the second material.

In an embodiment, the film layer 8 is formed by depositing one or more said second materials repeatedly. For example, the film layer 8 is formed by stacking the particles of pure zinc and pure copper.

Furthermore, in an embodiment, before the thermal spraying source 14 starts to operate, the surface of the body 4 or the pattern layer 6 on the surface undergoes surface treatment, such as sandblasting, chemical coarsening, laser etching, mechanical processing, or corona discharge process to roughen the surface of the body 4 or the pattern layer 6 on the surface and generate radicals for enhancing the adhesiveness or cohesiveness of the film layer 8. Sandblasting, chemical coarsening, laser etching, mechanical processing, and the corona discharge process are selected according to the material of which the body 4 is made. However, in a variant embodiment, capillaries on the surface of the body 4 (made of unglazed ceramic or a plastic film, for example,) are of a large diameter, such that it is feasible to operate the thermal spraying source 14 directly without performing the surface treatment but still attain the same effect.

Accordingly, the present invention provides a conductive pattern film substrate and a manufacturing method for forming a functional pattern layer on a body according to a pattern designed by a user, forming a film layer on the pattern layer directly, thereby enabling the film layer to acquire electrical characteristics of the pattern according to the pattern layer, and thereby combining two anisotropic materials, namely the body and the film layer, without assistance from an intermediate layer which is otherwise required by the prior art.

## Claims

1. A conductive pattern film substrate manufacturing method for combining two anisotropic materials, namely a patterned body and a film layer, without assistance from an intermediate layer, the method comprising the steps of:
producing a thermal spraying source for performing one of a heating operation and a spraying operation;
performing the heating operation on a film material to prepare the film material for at least one of thermal spraying and semi-thermal spraying, thereby melt the film material and transform it into ultra-fine particles to be shot onto the surface of aforesaid substrate into film particles;
forming a pattern layer on the body according to the pattern; and
spraying the film particles to the body by the spraying operation of the thermal spraying source to form the film layer containing the film particles on the pattern layer.

2. The manufacturing method of claim 1, wherein one of the pattern layer and the film layer is etched and/or shaped by one of positive etching and negative etching performed by an etching source, and the etching source is at least one of laser etching, mechanical processing, and chemical etching.

3. The manufacturing method of claim 1, further comprising forming a mask layer on the body, forming the pattern layer on the body according to the pattern by the mask layer, removing the mask layer after finalizing the pattern layer selectively, and forming the built-in pattern on the mask layer selectively.

4. The manufacturing method of claim 3, wherein the film particles are sprayed to the pattern layer through the mask layer having the pattern.

5. The manufacturing method of claim 2, wherein the etching source etches and shapes the pattern layer having a trench on the body.

6. The manufacturing method of claim 2, further comprising performing surface treatment to the body so as to form a rough surface thereon and thereby change mutual adhesiveness between the body and the film layer.

7. The manufacturing method of claim 6, wherein the surface treatment is performed by one of sandblasting, chemical coarsening, laser etching, mechanical processing, and corona discharge process.

8. The manufacturing method of claim 1, wherein at least one of the thermal-type thermal spraying source and the electrical-type thermal spraying source performs thermal spraying and semi-thermal spraying on the film material.

9. A conductive pattern film substrate, comprising:
a body made of a first material;
a pattern layer embedded in the body and having a pattern for producing electrical characteristics; and
a film layer made of a second material different from the first material and directly formed on the pattern layer by a thermal spraying source acting on the second material to enable the pattern layer to acquire electrical characteristics of the pattern by the film layer.

10. The conductive pattern film substrate of claim 9, wherein the pattern is at least one of an antenna pattern, an electrical circuit pattern, and a pattern of an appropriate shape.

11. The conductive pattern film substrate of claim 10, wherein the pattern layer in form of a trench is formed on the body, the trench being etched and shaped by an etching source, and the film layer on the pattern layer is of a thickness equal to or less than a depth of the trench.

12. The conductive pattern film substrate of claim 9, wherein the first material is one selected from the group consisting of acrylonitrile-butadiene-styrene copolymer (ABS), polycarbonate (PC), acrylonitrile-butadiene-styrene-polycarbonate copolymer (ABS+PC), polyethylene terephthalate (PET), polypropylene (PP), polyurethane (PU), polyimide (PI), polyamide (PA), poly(butylene terephthalate) (PBT), poly(methyl methacrylate) (PMMA), ceramic, metal, glass, and a combination thereof, and the second material is one selected from the group consisting of zinc, copper, aluminum, gold, iron, nickel, chromium, and a combination thereof.
